# EUROPEAN PATENT SPECIFICATION

(11) **EP 3 291 279 B1**
(45) Date of publication and mention of the grant of the patent: **05.05.2021**
(21) Application number: 16382414.7
(22) Date of filing: 06.09.2016
(51) Int. Cl.: H01J 37/32, C23C 16/48, C23C 16/511

(54) **DIAMOND MANUFACTURING SYSTEM AND METHOD VIA CHEMICAL VAPOR DEPOSITION ASSISTED WITH LASER INITIATED PLASMA FED WITH MICROWAVE ENERGY**
DIAMANTENHERSTELLUNGSVORRICHTUNG UND VERFAHREN ÜBER CHEMISCHE DAMPFABSCHEIDUNG MIT UNTERSTÜTZUNG EINES MIT MIKROWELLENENERGIE GESPEISTEN LASERINITIIERTEN PLASMAS
SYSTEME ET PROCEDE DE PRODUCTION DE DIAMANT PAR DEPOT CHIMIQUE EN PHASE VAPEUR PAR PLASMA ALIMENTE D'ENERGIE MICRO-ONDE ET ASSISTE PAR LASER

(43) Date of publication of application: 07.03.2018
(73) Proprietor: Nano Coatings, S.L., 50018 Zaragoza (ES)
(72) Inventor: MARTIN VELASCO, Pedro Julián, 50018 ZARAGOZA (ES); LENNIKOV, Vasily, 50018 ZARAGOZA (ES); LUACES OROBITG, Susana Maria, 50018 ZARAGOZA (ES); PALACIOS ZAMBRANO, Elena, 50018 ZARAGOZA (ES)
(74) Representative: Ungria López, Javier

(56) References cited:
- EP-A2- 0 764 969
- JP-A- H0 570 291
- JP-A- S62 171 990
- US-A- 4 986 214
- US-A1- 2015 031 151
- METEV ET AL: "Laser-assisted ECR-plasma-CVD of a-C:H films", DIAMOND AND RELATED MATERIALS, ELSEVIER SCIENCE PUBLISHERS, AMSTERDAM, NL, vol. 5, no. 3-5, 1 April 1996 (1996-04-01) , pages 420-424, XP005309787, ISSN: 0925-9635, DOI: 10.1016/0925-9635(95)00460-2

## Description

### Object of the invention

The present invention is referred to a diamond manufacturing system via chemical vapor deposition assisted with laser-initiated plasma fed with microwave energy.

The present invention is also referred to a method of diamond manufacturing via chemical vapor deposition assisted with plasma fed with microwave energy initiated by at least one laser beam.

The system and the method mentioned in the present invention have application, for example, in the industry dedicated to the diamond production for electronics, machining, chemistry, biomedical and optical applications, as well as for jewelry.

### Technical problem to resolve and the Antecedents of the invention

The huge scale diamond production for various applications such as chemical, biomedical, electronics, machining, etc. was during the time the main objective for research laboratories as well as industry.

Diamond shows excellent mechanical properties such as high hardness (-100 GPa) and the highest compression module among known materials. It is an inert material with very high thermal conductivity. It is a good dielectric with enhanced limit of the disruption voltage. Doped diamond exhibits good electrons and holes mobility. Diamond exhibits excellent optical properties which are the result of a high transparency in all wavelengths, from the deep UV to the high wavelength infrared.

In the past thirty years the technology for small scale diamond crystals and coatings deposition was developed. This technology, called Chemical Vapor Deposition (CVD), is based on a plasma generation which contains methyl radicals, followed by carbon deposition on a substrate in form of diamond. The substrate for coating application could be diamond, in this case diamond coatings are called homoepitaxial, or the substrate could be a material different from diamond (typically silicon monocrystal) and in this case the films are called heteroepitaxial.

For diamond film production on a particular substrate, the substrate is placed in a reactor and a hydrocarbon, usually methane, containing gas mixture is introduced. Other components of the mixture are generally argon and hydrogen. Their function is to favor diamond formation instead of graphite. The atomic hydrogen, formed by excitation of the molecular hydrogen produces the kinetic stabilization of carbon in diamond phase. The gas mixture is introduced at low pressure and it is excited inside of the reactor by some plasma generation technology, able to achieve the suitable energy density for the process. Finally, the carbon contained in the plasma is deposited in diamond phase on the substrate surface.

The preferred technology for gas mixture heating inside the reactor is microwave heating. This technology results in an efficient plasma formation and reasonable energy efficiency.

Documents WO 2012/084657 A1 and WO 2012/084655 A2 are known in the prior art. These documents describe a method and a reactor for industrial diamond production and suitable substrates for this process.

According to the documents mentioned in the previous paragraph, the employed reactors have a structure with a high electrical conductivity near the sample holder. This structure allows generating an electric field distribution asymmetry in the reactor, resulted in a high electric field peak near the sample holder structure. Thus a better gas microwave heating is achieved in the zone near the sample holder and the plasma concentration there is increased. The corresponding structure is called "plasma stabilizer ring", due to its ring form and because of the plasma stabilization function in the zone near the substrate.

The method described in the mentioned documents enhances the efficiency of the diamond production in comparison to previous methods, but the growth speed of the diamond is still very limited (about some microns per hour).

To increase the diamond growth rate on the substrate surface, some other components like nitrogen are intended to add to the plasma forming gas. This technique has not succeeded to definitively increase the growth rate, but as a secondary effect, some color was added to the resulted diamond. The color drastically decrease the optical properties of diamond, thus the obtained materials have limited application field.

Document JP H05 70291 A is known from the prior art. This document discloses a method and equipment for diamond synthesis aimed to uniformly synthesize a diamond film of good crystallinity on a three-dimensional substrate.

Document *"*Laser assisted ECR-plasma-CVD of a-C:H films" (DIAMOND AND RELATED MATERIALS, ELSEVIER SCIENCE PUBLISHERS, AMSTERDAM, NL, vol. 5, No. 3-5, 1 April 1996) is also known from the prior art. This document deals with laser-induced structural transformations in a-C:H films.

Document US 4986214 A is also known from the prior art. This document discloses an apparatus for forming, by means of laser projection and a thin-film forming gas, a thin film over the surface of a substrate.

### Description of the invention

In order to provide a solution for efficient industrial diamond production, the system and method of diamond manufacturing via chemical vapor deposition assisted with laser-initiated plasma fed with microwave energy, object of the present invention, is described below.

The system of diamond manufacturing via chemical vapor deposition assisted with laser-initiated plasma fed with microwave energy, object of the present invention, includes, conventionally, a reactor with a gas inlet and a gas outlet.

The gas inlet is configured for the introduction of a carbon and hydrogen rich gas into the reactor. The gas introduced in the reactor is preferably a mixture of gases which contains a carbon precursor, typically a hydrocarbon. The gas outlet is configured for the extraction of the gases from the reactor.

The reactor is conventionally equipped with a microwave heating system configured to heat the gas introduced into the reactor and generate plasma from this gas.

The reactor is additionally equipped with a sample holder in the interior, configured for substrate holding. The substrate is provided for the diamond formation on its surface.

The main novelty of the system of diamond manufacturing via chemical vapor deposition assisted with laser-initiated plasma fed with microwave energy, object of the present invention, consists in the linking of the reactor with a laser source by a laser beam direction means.

The laser source and the laser beam direction means are configured to generate and project at least one laser beam inside of the reactor and direct the at least one laser beam towards the substrate.

Preferably, the system comprises a motorized Z axis, configured to vary the position of the sample holder inside the reactor.

In accordance with a preferred embodiment, the reactor comprises a window (typically made from quartz). At least one laser beam from the laser source is projected through this window, by means of laser beam direction means, to the substrate.

The laser beam direction means are preferably linked to a focalizing lens configured to produce the maximum energy incidence point of the at least one laser beam on the substrate surface.

In accordance with a preferred embodiment, the diamond manufacturing system, object of the present invention, comprises gas flow control means configured to control the gas flow (of the gas mixture), introduced in the reactor.

Preferably, the gas flow control means are configured to control individually the flow of each component of the gas mixture introduced in the reactor.

Also in accordance with a preferred embodiment of the diamond manufacturing system viachemical vapor deposition assisted with laser-initiated plasma fed with microwave energy, there is a protection case configured to protect the laser source and the laser direction means from the influence of the microwaves coming from the inside of the reactor.

Preferably, the sample holder is provided by substrate heating means (typically, an electric resistance) and substrate temperature control means (typically at least one pyrometer).

Preferably, the gas (gases mixture) introduced in the reactor contains methane as carbon source.

Preferably, said gas (or gases mixture) contains not only carbon precursor and hydrogen, but also argon and nitrogen.

As it has already been introduced, the present invention also refers to a diamond manufacturing method viachemical vapor deposition assisted with laser-initiated plasma fed with microwave energy.

The diamond manufacturing method via chemical vapor deposition assisted with laser-initiated plasma fed with microwave energy, object of this invention includes, generally, introducing a substrate into the reactor and positioning the substrate on the sample holder inside the reactor. The method also includes introducing a gas (gases mixture) rich in carbon and hydrogen inside the reactor through a gas inlet and extracting the remaining gas (gases mixture) from the reactor through a gas outlet.

In a novel way, the diamond manufacturing method via chemical vapor deposition assisted with laser-initiated plasma fed with microwave energy, object of this invention, includes generating at least one laser beam by a laser source and projecting and directing the at least one laser beam towards the substrate by means of laser beam direction means inside of reactor.

The at least one laser beam is projected on the substrate surface to clean the substrate surface and to induce a heating of the substrate surface and a discharge (formation) of plasma near the substrate surface which promotes the carbon deposition in diamond phase on the substrate surface.

The laser beam direction means scan the desired part of the substrate surface (eventually, the whole substrate surface), promoting the formation of a diamond coating on the scanned part of the substrate surface.

Preferably, the gas (gases mixture), rich in carbon and hydrogen, introduced in the reactor contains methane as a carbon precursor.

Preferably, the gas (gases mixture), rich in carbon and hydrogen, introduced in the reactor contains also argon and nitrogen.

The method preferably comprises heating the sample holder to produce a heating of the substrate that promotes the diamond formation on the substrate surface.

Additionally, the method preferably comprises moving the sample holder inside the reactor by means of a Z-axis motor (or any alternative Z-axis movement system) to locate the substrate in a determinate (optimal) plasma generation zone inside the reactor.

### Short description of the figures

As part of the explanation of at least one preferred embodiment of the diamond manufacturing system and method viachemical vapor deposition assisted with laser-initiated plasma fed with microwave energy, the following figure has been included:

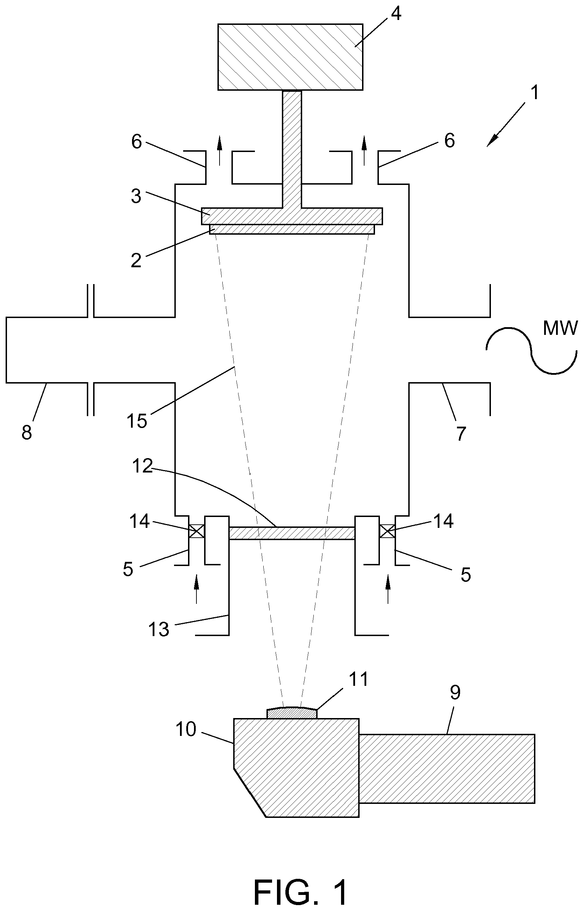

Figure 1: Shows a schematic view of one embodiment of the diamond manufacturing system viachemical vapor deposition assisted with laser-initiated plasma fed with microwave energy.

### Detailed description

The present invention refers to, as mentioned before, a system and a method of diamond production by chemical vapor deposition assisted with laser-initiated microwave-fed plasma.

Figure 1 shows a schematic view of one exemplary embodiment of the diamond manufacturing system viachemical vapor deposition assisted with laser-initiated plasma fed with microwave energy, object of the present invention.

The diamond manufacturing system via chemical vapor deposition assisted with laser-initiated plasma fed with microwave energy, object of this invention, comprises a reactor (1) configured in such a way that the formation of a diamond coating on a substrate (2) introduced into the reactor (1) is produced within the interior of the reactor (1).

The substrate (2) is put on a sample holder (3) which is placed inside the reactor (1). With a motorized Z axis (4) it is possible to adjust the sample holder (3) position (and, hence, also the substrate (2) position), in order to favor plasma formation onto the substrate (2) surface, as sample holder (3) position is varied inside the reactor (1).

The reactor (1) is connected to at least one gas inlet (5) and at least one gas outlet (6), configured respectively for the introduction and extraction into and from the reactor (1), of a gas mixture preferably composed by methane, hydrogen, argon and nitrogen. Eventually, the gas may comprise also additional components.

The gas pressure introduced into the reactor is preferably between 10 and 1100 mBar.

Preferably the gas inlet into the reactor (1) is controlled by flow control means (14), which guarantee a flow comprised preferably between 10 and 2000 sccm (cm³/min, under normal conditions).

As it has been advanced, the reactor (1) is equipped of a microwave (MW) heating system that consists of a wave guide (7) for microwaves entrance in the reactor (1) and microwaves absorption means (8). The microwave source is typically a magnetron that generates microwaves in a range of frequencies comprised between 915 MHz and 2450 MHz. Microwaves power is comprised preferably between 10 W and 100 kW, depending on the required productivity.

Gas heating induce the formation of a plasma where molecular hydrogen (H₂) is dissociated in hydrogen atoms.

At the mentioned microwave frequencies, the formation of methyl radicals (-CH₃) is promoted from methane contained in the gas. However, this formation of methyl radicals takes place in a limited area of the reactor (1) hence it does not allow to achieve a satisfactory deposition rate and growth of diamond coating onto the substrate (2).

In a novel fashion, the diamond manufacturing system object of the present invention comprises a laser system for the initiation of plasma formation onto the substrate (2). Mentioned laser comprises a laser source (9), laser beam direction means (10), and a laser focal lens (11).

The laser system is connected to the reactor (1) through a window (12), typically made from quartz, and a protection case (13), configured to protect the laser system from microwaves existing inside the reactor (1) when this is working.

In order to widen the production area of methyl radicals and favor diamond deposition onto substrate (2) surface, laser beam direction means (10) scan with at least one laser beam preferably all the substrate (2) surface.

The substrate (2) heating due to the laser beam starts a plasma formation over the substrate (2) surface. Furthermore, this plasma is fed by microwave energy. Methyl radicals are generated in the mentioned plasma and carbon deposition is favored in those places where laser beam is directed to the substrate (2).

Additionally, atomic hydrogen in the plasma produces the kinetic stabilization of diamond phase of carbon and favoring, hence, the diamond coating formation onto the substrate (2).

The laser system, due to the laser beam direction means (10), contributes to a wide scanning area (15) in which laser is able to move. This allows to cover a large substrate (2) surface for diamond coating of the substrate (2).

The laser beam direction means (10), according to various embodiments, may comprise a set of rotating or galvanic mirrors.

By means of the laser source (9) and laser beam direction means (10) it is possible to adjust the scanning rate on the substrate (2) surface, the scanning pattern and laser beam parameters, such as intensity, pulse, etc.

Substrate (2) temperature and, specifically, substrate (2) surface temperature must be controlled in order to ensure an appropriate diamond growth rate on the substrate (2) surface.

In order to control substrate temperature, the sample holder (3) is equipped with temperature control means (not represented) (typically comprising at least one calibrated pyrometer), and with heating means (not represented) (typically at least one electric resistance).

The sample holder (3) is typically made of molybdenum.

Preferably, the sample holder (3) is equipped with attaching means (not represented), configured to attach the substrate (2) to the sample holder (3). This is essential in those reactor (1) configurations in which the substrate (2) is placed in the upper part of the reactor (1), under the sample holder (3), as shown in Figure 1. The attaching means may comprise a set of screws and nuts, a clamp, fastening straps, or any attaching way able to attach the substrate (2) to the sample holder (3).

However, in an alternative configuration (not represented), the substrate (2) could be situated on the sample holder (3), at the lower part of the reactor (1), not being required those attaching means for the sample holder (3), being enough the deposition of the free standing substrate (2) on the sample holder (3). In this case the laser system would be placed at the upper part of the reactor (1), directing the laser beam downwards (to the substrate (2)).

The main parameters to be controlled in the diamond manufacturing system, having an influence on the diamond formation and diamond growth rate are:

### Gas flow and gas composition introduced into the reactor (1):

The specific components of the gas mixture put into the reactor, as well as the gas flow will depend on the type of substrate (2) and the desired production (desired diamond growth rate). Preferably, the gas flow control means (14) may control individually the gas flow of every gas component introduced into the reactor (1).

Depending on the gas required composition in volume inside the reactor (1), hydrogen an argon are introduced typically in a flow that can achieve 2000 sccm, whereas methane and dopant elements are introduced with a gas flow that can achieve 50 sccm.

### Reactor pressure (1):

Pressure is preferably controlled by means of a vacuum controller (not represented). Generally, pressure is kept in a range comprised between 10 and 1100 mBar, depending on the diamond properties that want to be achieved and desired growth rate. For an optimal operation it is recommended to keep a pressure inside the reactor between 100 and 800 mBar.

### Laser type

The laser source (9) may emit laser radiation of several wavelengths. The laser wavelength typically depends on the laser type. If diode laser or diode pumped neodymium laser is used, the fundamental wavelength may typically range from 0.8 µm to 1.1 µm. If CO₂ laser is used, wavelength is about 10.6 µm. However, due to production needs, any available lasers with any wavelength may be used.

### Laser parameters

The laser source (9) can apply continuous laser or pulsed laser with frequencies typically between 10 Hz and 10 MHz, to get the optimal diamond coating growth rate. The laser power typically ranges from 1 W to 5000 W. The recommended laser power regime is the one that allows the laser to only operate for the ignition of the plasma, the laser being further fed with microwave power, over the substrate (2) surface. Thus, the laser power would be preferably 10 times lower than the used microwave power.

Preferably, a *Q-switched* laser beam is used, with an approximate wavelength of 1.064 nm and a power interval ranged between 5 and 50W.

Preferably, the approximate pulse laser duration is 100 ns and the pulse frequency ranges from 20 to 90 kHz.

The focal distance to apply will depend on the laser type and the reactor (1) size. Typically this distance is from 50 to 1000mm. With a suitable choice of the focalization lens (11), typically with focal distance about 360 mm, it is possible to concentrate the appropriate amount of energy just on the substrate (2) surface.

The laser beam direction means (10) allow to obtain a scanning area (15) broad enough to scan the whole area of the substrate (2).

The protection case (13) protects the laser system from the microwaves existing inside the reactor.

### Substrate (2) temperature

This factor plays a crucial role to obtain the desired diamond coating growth rate. This temperature is controlled in a way that it is preferably in a range from 350°C to 1300°C.

### Microwave power and frequency

The microwave heating system provides the necessary microwave power to be introduced into the reactor (1) for gas heating and plasma stabilization.

The microwave power must be maintained in a sufficient range to make possible the laser initiation of plasma (fed by microwave power) on the substrate (2) surface. The power will depend in each case on the used microwave frequency. The approximate power ranges from 10W to 100kW.

The motorized Z axis (4) allows to move the sample holder (3) and to drive it to an appropriate position for the plasma formation over the substrate (2) surface. The same may be achieved, as it was stated before, by optimal laser beam focalization on the substrate (2) surface.

The assembly of the sample holder (3), reactor walls (1) and microwave absorption mediums (8) forms the microwave resonator with the dimensions preferably selected for TM (transversal magnetic) mode operation. The fine adjustment of microwave impedance can be made with a regulated short circuit, integrated in the microwave absorption means (8), considering the dimensions of the assembly of the microwave generator (not represented) and the waveguide (7) for the microwave entrance.

The microwave heating system has an entrance impedance adapter to adjust the power absorbed by the microwave heating system.

Preferably, the power of the microwave heating system reaches up to 3000W and the frequency 2450MHz.

In accordance with a particular embodiment, the waveguide (7) as well as the microwave absorption means (8) are made according to the standard WR340 form factor, corresponding to rectangular tubes with a size of 3.40x1.70 square inches (8.64x4.32 cm²).

Preferably, the microwave heating system includes a high voltage source that feed the microwave source magnetron. The high voltage source has a microwave power stabilizer, based on the reflected power value measured in a specific point of the electromagnetic circuit.

As it was introduced, the present invention is also referred to a diamond manufacturing method viachemical vapor deposition assisted with laser-initiated plasma fed with microwave energy.

The diamond manufacturing method, object of the present invention comprises providing a substrate (2) in a sample holder (3) inside the reactor (1) configured to heat the substrate by means of microwave.

Introducing a gas flow, consisting of methane and molecular hydrogen, inside the reactor (1).

Activating the microwave heating system to heat the gas introduced into the reactor (1).

Moving the sample holder (3) by the motorized Z axis (4) to induce the plasma generation preferably in the zone near the substrate (2) surface.

Activating the laser system to project a laser beam onto the substrate (2) surface to promote the plasma discharge initiation fed by microwave energy over a particular point on the laser heated substrate (2) surface. By means of this discharge the carbon from the plasma is deposited on the substrate (2) surface in diamond phase.

Activating laser beam direction means (10) to scan the substrate surface (2) with the laser beam, thus permitting to cover the desired part of the substrate surface (2) inducing the formation of a diamond coating on the mentioned part of the substrate surface.

## Claims

1. Diamond manufacturing system via chemical vapor deposition assisted with laser initiated plasma fed with microwave energy which comprises a reactor (1), equipped with a gas inlet (5) configured for introducing a carbon-and-hydrogen rich gas into the reactor (1), wherein the reactor (1) comprises a gas outlet (6) configured for extracting the gas from the reactor (1), wherein the reactor (1) is equipped with a microwave heating system configured to heat the gas introduced into the reactor and to stabilize a plasma formed from this gas, wherein the reactor (1) is additionally equipped with a sample holder (3) inside the reactor (1), configured to hold a substrate (2) provided for surface diamond formation, wherein the diamond manufacturing system comprises a laser source (9) and laser beam direction means (10), linked to the reactor (1) and configured to project at least one laser beam into the reactor (1) and to direct the at least one laser beam towards the substrate (2), **characterized in that** the laser beam direction means (10) are linked to a focalizing lens (11) configured to produce a maximum energy incidence point of the at least one laser beam on the substrate surface (2), such that the diamond manufacturing system is configured to:
- scan a part of the substrate (2) surface by the laser beam, by means of the laser beam direction means (10);
- clean the substrate (2) surface by means of the laser beam;
- induce plasma formation at the surface of the substrate (2), upon heating the surface of the substrate (2) with the laser beam, thereby promoting diamond-phase carbon deposition on the substrate (2) surface.

2. Diamond manufacturing system via chemical vapor deposition assisted with laser initiated plasma fed with microwave energy according to claim 1, **characterized in that** it comprises a motorized Z axis(4) configured to modify the position of the sample holder (3) inside the reactor (1).

3. Diamond manufacturing system via chemical vapor deposition assisted with laser initiated plasma fed with microwave energy according to claim 1, **characterized in that** the reactor (1) comprises a window (12) through which the at least one laser beam is projected towards the substrate (2) from the laser source (9) by means of the laser beam direction means (10).

4. Diamond manufacturing system via chemical vapor deposition assisted with laser initiated plasma fed with microwave energy according to claim 1, **characterized in that** the reactor (1) comprises gas flow control means (14) configured to control the flow of gas introduced into the reactor (1).

5. Diamond manufacturing system via chemical vapor deposition assisted with laser initiated plasma fed with microwave energy according to claim 1, **characterized in that** the gas flow control means (14) are configured to individually control the flow of each constituent of the gas introduced into the reactor (1).

6. Diamond manufacturing system via chemical vapor deposition assisted with laser initiated plasma fed with microwave energy according to claim 1, **characterized in that** it comprises a protection case (13) configured to protect the laser source (9) and the laser direction means (10) from the influence of microwaves coming from inside the reactor (1).

7. Diamond manufacturing system via chemical vapor deposition assisted with laser initiated plasma fed with microwave energy according to claim 1, **characterized in that** the sample holder (3) is provided with substrate (2) heating means and substrate (2) temperature control means.

8. Diamond manufacturing system via chemical vapor deposition assisted with laser initiated plasma fed with microwave energy according to claim 1, **characterized in that** the gas introduced into the reactor (1) comprises methane.

9. Diamond manufacturing method via chemical vapor deposition assisted with laser initiated plasma fed with microwave energy which comprises introducing a substrate (2) inside a reactor (1) and positioning the substrate (2) on a sample holder (3) in the interior of the reactor (1), introducing a carbon-and-hydrogen rich gas inside the reactor (1) through a gas inlet (5), extracting gas from the reactor through a gas outlet (6), heating the gas inside the reactor (1) by means of a microwave heating system to stabilize a plasma formed from this gas, wherein the method comprises generating at least one laser beam by means of a laser source (9) and projecting and directing the at least one laser beam into the reactor (1) towards the substrate (2) by means of laser beam direction means (10); **characterized in that** a part of the substrate (2) surface is scanned by the laser beam by means of the laser beam direction means (10); wherein the at least one laser beam is projected onto the substrate (2) surface so that it cleans the substrate surface and induces a substrate heating that promotes the plasma formation and the diamond-phase carbon deposition on the substrate (2) surface scanned part.

10. Diamond manufacturing method via chemical vapor deposition assisted with laser initiated plasma fed with microwave energy according to claim 9, **characterized in that** the carbon-and-hydrogen rich gas comprises methane.

11. Diamond manufacturing method via chemical vapor deposition assisted with laser initiated plasma fed with microwave energy according to claim 9, **characterized in that** it comprises heating the sample holder (3) to produce a substrate heating (2) which promotes the diamond formation on the substrate (2) surface.

12. Diamond manufacturing method via chemical vapor deposition assisted with laser initiated plasma fed with microwave energy according to claim 9, **characterized in that** it comprises moving the sample holder (3) inside the reactor (1) by means of a motorized Z axis (4).

## Patentansprüche

1. Diamantherstellungssystem mittels chemischer Gasphasenabscheidung, unterstützt durch laserinitiiertes Plasma, das mit Mikrowellenenergie gespeist wird, welches einen Reaktor (1) umfasst, der mit einem Gaseinlass (5) ausgestattet ist, der dazu ausgelegt ist, ein kohlenstoff- und wasserstoffreiches Gas in den Reaktor (1) einzuleiten, wobei der Reaktor (1) einen Gasauslass (6) umfasst, der zum Extrahieren des Gases aus dem Reaktor (1) ausgelegt ist, wobei der Reaktor (1) mit einem Mikrowellenheizsystem ausgestattet ist, das dazu ausgelegt ist, das in den Reaktor eingeleitete Gas zu erwärmen und ein aus diesem Gas gebildetes Plasma zu stabilisieren, wobei der Reaktor (1) zusätzlich mit einem Probenhalter (3) innerhalb des Reaktors (1) ausgestattet ist, der dazu ausgelegt ist, ein Substrat (2) zu halten, das für die Oberflächendiamantbildung vorgesehen ist, wobei
das Diamantherstellungssystem eine Laserquelle (9) und Laserstrahl-Richtungsmittel (10) umfasst, die mit dem Reaktor (1) verbunden sind und dazu ausgelegt sind, mindestens einen Laserstrahl in den Reaktor (1) zu projizieren und den mindestens einen Laserstrahl auf das Substrat (2) zu richten,
**dadurch gekennzeichnet, dass**
die Laserstrahl-Richtungsmittel (10) mit einer Fokussierungslinse (11) verbunden sind, die dazu ausgelegt ist, einen Einfallspunkt maximaler Energie des mindestens einen Laserstrahls auf der Substratoberfläche (2) zu erzeugen, so dass das Diamantherstellungssystem zu Folgendem ausgelegt ist:
- Abtasten eines Teils der Oberfläche des Substrats (2) mit dem Laserstrahl, und zwar mit Hilfe der Laserstrahl-Richtungsmittel (10);
- Reinigen der Oberfläche des Substrats (2) mithilfe des Laserstrahls;
- Induzieren von Plasmabildung an der Oberfläche des Substrats (2) beim Erwärmen der Oberfläche des Substrats (2) mit dem Laserstrahl, dadurch Fördern der Abscheidung von Kohlenstoff aus der Diamantphase auf der Oberfläche des Substrats (2).

2. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** es eine motorisierte Z-Achse (4) umfasst, die zum Modifizieren der Position des Probenhalters (3) innerhalb des Reaktors (1) ausgelegt ist.

3. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** der Reaktor (1) ein Fenster (12) umfasst, durch das der mindestens eine Laserstrahl in Richtung des Substrats (2) von der Laserquelle (9) mithilfe der Laserstrahl-Richtungsmittel (10) projiziert wird.

4. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** der Reaktor (1) Gasströmungssteuerungsmittel (14) umfasst, die dazu ausgelegt sind, die Strömung des in den Reaktor (1) eingeleiteten Gases zu steuern.

5. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** die Gasströmungssteuerungsmittel (14) dazu ausgelegt sind, die Strömung jedes Bestandteils des in den Reaktor (1) eingeleiteten Gases individuell zu steuern.

6. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** es ein Schutzgehäuse (13) umfasst, das dazu ausgelegt ist, die Laserquelle (9) und die Laserrichtungsmittel (10) vor dem Einfluss der Mikrowellen zu schützen, die aus dem Inneren des Reaktors (1) kommen.

7. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** der Probenhalter (3) mit Heizmitteln für das Substrat (2) und Temperatursteuerungsmitteln für das Substrat (2) versehen ist.

8. Diamantherstellungssystem mittels chemischer Gasphasenabscheidung, unterstützt durch laserinitiiertes Plasma, das mit Mikrowellenenergie gespeist wird, nach Anspruch 1, **dadurch gekennzeichnet, dass** das in den Reaktor (1) eingeleitete Gas Methan umfasst.

9. Diamantherstellungsverfahren mittels chemischer Gasphasenabscheidung, unterstützt durch laserinitiiertes Plasma, das mit Mikrowellenenergie gespeist wird, welches das Einführen eines Substrats (2) in einen Reaktor (1) und das Positionieren des Substrats (2) auf einem Probenhalter (3) im Inneren des Reaktors (1) umfasst, das Einführen eines kohlenstoff- und wasserstoffreichen Gases in den Reaktor (1) durch einen Gaseinlass (5), das Extrahieren von Gas aus dem Reaktor durch einen Gasauslass (6), das Erwärmen des Gases in dem Reaktor (1) mittels eines Mikrowellen-Heizsystems zur Stabilisierung eines aus diesem Gas gebildeten Plasmas,
wobei das Verfahren das Erzeugen mindestens eines Laserstrahls mittels einer Laserquelle (9) und das Projizieren und Richten des mindestens einen Laserstrahls in den Reaktor (1) in Richtung des Substrats (2) mithilfe von Laserstrahl-Richtungsmitteln (10) umfasst;
**dadurch gekennzeichnet, dass**
ein Teil der Oberfläche des Substrats (2) durch den Laserstrahl mithilfe der Laserstrahl-Richtungsmittel (10) abgetastet wird; wobei der mindestens eine Laserstrahl auf die Oberfläche des Substrats (2) projiziert wird, so dass er die Substratoberfläche reinigt und eine Erwärmung des Substrats induziert, welche die Plasmabildung und die Abscheidung von Kohlenstoff aus der Diamantphase auf dem abgetasteten Teil der Oberfläche des Substrats (2) fördert.

10. Diamantherstellungsverfahren mittels chemischer Gasphasenabscheidung, unterstützt durch laserinitiiertes Plasma, das mit Mikrowellenenergie gespeist wird, nach Anspruch 9, **dadurch gekennzeichnet, dass** das kohlenstoff- und wasserstoffreiche Gas Methan umfasst.

11. Diamantherstellungsverfahren mittels chemischer Gasphasenabscheidung, unterstützt durch laserinitiiertes Plasma, das mit Mikrowellenenergie gespeist wird, nach Anspruch 9, **dadurch gekennzeichnet, dass** es das Erwärmen des Probenhalters (3) umfasst, um eine Erwärmung des Substrats (2) zu erzeugen, welche die Diamantbildung auf der Oberfläche des Substrats (2) fördert.

12. Diamantherstellungsverfahren mittels chemischer Gasphasenabscheidung, unterstützt durch laserinitiiertes Plasma, das mit Mikrowellenenergie gespeist wird, nach Anspruch 9, **dadurch gekennzeichnet, dass** es das Bewegen des Probenhalters (3) im Inneren des Reaktors (1) mithilfe einer motorisierten Z-Achse (4) umfasst.

## Revendications

1. Système de fabrication de diamant par dépôt chimique en phase vapeur assisté par un plasma initié par laser alimenté en énergie micro-ondes, qui comprend un réacteur (1), équipé d'une entrée de gaz (5) configurée pour introduire un gaz riche en carbone et en hydrogène dans le réacteur (1), le réacteur (1) comprenant une sortie de gaz (6) configurée pour extraire le gaz hors du réacteur (1), le réacteur (1) étant équipé d'un système de chauffage par micro-ondes configuré pour chauffer le gaz introduit dans le réacteur et pour stabiliser un plasma formé à partir de ce gaz, le réacteur (1) étant en outre équipé d'un porte-échantillon (3) à l'intérieur du réacteur (1), configuré pour maintenir un substrat (2) prévu pour la formation de diamant en surface, le système de fabrication de diamant comprenant une source laser (9) et des moyens (10) de direction de faisceau laser, reliés au réacteur (1) et configurés pour projeter au moins un faisceau laser dans le réacteur (1) et pour diriger ledit au moins un faisceau laser vers le substrat (2), **caractérisé en ce que** les moyens (10) de direction de faisceau laser sont reliés à une lentille de focalisation (11) configurée pour produire un point d'incidence d'énergie maximale dudit au moins un faisceau laser sur la surface du substrat (2), de telle sorte que le système de fabrication de diamants soit configuré pour :
- balayer une partie de la surface du substrat (2) par le faisceau laser, au moyen des moyens (10) de direction de faisceau laser ;
- nettoyer la surface du substrat (2) au moyen du faisceau laser ;
- induire la formation de plasma à la surface du substrat (2), en chauffant la surface du substrat (2) avec le faisceau laser, favorisant ainsi le dépôt de carbone en phase diamant sur la surface du substrat (2)

2. Système de fabrication de diamant par dépôt chimique en phase vapeur assisté par un plasma initié par laser et alimenté en énergie micro-ondes selon la revendication 1, **caractérisé en ce qu'**il comprend un axe Z motorisé (4) configuré pour modifier la position du porte-échantillon (3) à l'intérieur du réacteur (1)

3. Système de fabrication de diamant par dépôt chimique en phase vapeur assisté par un plasma initié par laser alimenté en énergie micro-ondes selon la revendication 1, **caractérisé en ce que** le réacteur (1) comprend une fenêtre (12) à travers laquelle ledit au moins un faisceau laser est projeté vers le substrat (2) à partir de la source laser (9) au moyen des moyens (10) de direction de faisceau laser.

4. Système de fabrication de diamant par dépôt chimique en phase vapeur assisté par un plasma initié par laser alimenté en énergie micro-ondes selon la revendication 1, **caractérisé en ce que** le réacteur (1) comprend des moyens (14) de commande du flux de gaz configurés pour commander le flux de gaz introduit dans le réacteur (1).

5. Système de fabrication de diamant par dépôt chimique en phase vapeur assisté par un plasma initié par laser alimenté en énergie micro-ondes selon la revendication 1, **caractérisé en ce que** les moyens (14) de commande du flux de gaz sont configurés pour commander individuellement le débit de chaque constituant du gaz introduit dans le réacteur (1).

6. Système de fabrication de diamant par dépôt chimique en phase vapeur assisté par un plasma initié par laser alimenté en énergie micro-ondes selon la revendication 1, **caractérisé en ce qu'**il comprend une enveloppe de protection (13) configurée pour protéger la source laser (9) et les moyens (10) de direction du laser de l'influence des micro-ondes provenant de l'intérieur du réacteur (1).

7. Système de fabrication de diamant par dépôt chimique en phase vapeur assisté par un plasma initié par laser alimenté en énergie micro-ondes selon la revendication 1, **caractérisé en ce que** le porte-échantillon (3) est pourvu de moyens (2) de chauffage du substrat et de moyens (2) de commande de la température du substrat.

8. Système de fabrication de diamant par dépôt chimique en phase vapeur assisté par un plasma initié par laser alimenté en énergie micro-ondes selon la revendication 1, **caractérisé en ce que** le gaz introduit dans le réacteur (1) comprend du méthane.

9. Procédé de fabrication de diamant par dépôt chimique en phase vapeur assisté par un plasma initié par laser alimenté en énergie micro-ondes, qui comprend le fait d'introduire un substrat (2) à l'intérieur d'un réacteur (1) et de positionner le substrat (2) sur un porte-échantillon (3) à l'intérieur du réacteur (1), le fait d'introduire un gaz riche en carbone et en hydrogène à l'intérieur du réacteur (1) par une entrée de gaz (5), le fait d'extraire le gaz hors du réacteur par une sortie de gaz (6), le fait de chauffer le gaz à l'intérieur du réacteur (1) au moyen d'un système de chauffage par micro-ondes pour stabiliser un plasma formé à partir de ce gaz, le procédé comprenant le fait de générer au moins un faisceau laser au moyen d'une source laser (9) et le fait de projeter et de diriger ledit au moins un faisceau laser dans le réacteur (1) vers le substrat (2) au moyen de moyens (10) de direction de faisceau laser ; **caractérisé en ce qu'**une partie de la surface du substrat (2) est balayée par le faisceau laser au moyen des moyens (10) de direction de faisceau laser ; ledit au moins un faisceau laser est projeté sur la surface du substrat (2) de sorte qu'il nettoie la surface du substrat et induit un chauffage du substrat qui favorise la formation de plasma et le dépôt de carbone en phase diamant sur la partie balayée de la surface du substrat (2).

10. Procédé de fabrication de diamant par dépôt chimique en phase vapeur assisté par un plasma initié par laser alimenté en énergie micro-ondes selon la revendication 9, **caractérisé en ce que** le gaz riche en carbone et en hydrogène comprend du méthane.

11. Procédé de fabrication de diamant par dépôt chimique en phase vapeur assisté par un plasma initié par laser alimenté en énergie micro-ondes selon la revendication 9, **caractérisé en ce qu'**il comprend le fait de chauffer le porte-échantillon (3) pour produire un chauffage du substrat (2) qui favorise la formation de diamant sur la surface du substrat (2).

12. Procédé de fabrication de diamant par dépôt chimique en phase vapeur assisté par un plasma initié par laser alimenté en énergie micro-ondes selon la revendication 9, **caractérisé en ce qu'**il comprend le fait de déplacer le porte-échantillon (3) à l'intérieur du réacteur (1) au moyen d'un axe Z motorisé (4).
